## Europäisches Patentamt

## European Patent Office

## Office européen des brevets

(11) Veröffentlichungsnummer: **0 019 813**
**B1**

(12) **EUROPÄISCHE PATENTSCHRIFT**

(45) Veröffentlichungstag der Patentschrift:
28.03.84

(51) Int. Cl.³: **H 03 K 17/96, H 03 K 17/725**

(21) Anmeldenummer: **80102730.1**

(22) Anmeldetag: **16.05.80**

(54) **Elektronischer Sensor-Ein/Aus-Schalter.**

(30) Priorität: **31.05.79 DE 2922309**

(43) Veröffentlichungstag der Anmeldung:
**10.12.80 Patentblatt 80/25**

(45) Bekanntmachung des Hinweises auf die Patenterteilung:
**28.03.84 Patentblatt 84/13**

(84) Benannte Vertragsstaaten:
**FR GB IT**

(56) Entgegenhaltungen:
**DE - A - 2 218 285**
**DE - A - 2 313 942**
**FR - A - 2 224 942**

(73) Patentinhaber: **SIEMENS AKTIENGESELLSCHAFT,
Berlin und München Wittelsbacherplatz 2,
D-8000 München 2 (DE)**

(72) Erfinder: **Hauenstein, Alfred, Ing.-grad., Terofalstrasse 3,
D-8000 München 21 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Elektronischer Sensor-Ein/Aus-Schalter

Die vorliegende Erfindung betrifft einen elektronischen Sensor-Ein/Aus-Schalter für eine an einem insbesondere als Zweidraht-Leitung ausgebildeten Wechselspannungsnetz liegende Last mit einem in Reihe zur Last liegenden steuerbaren Halbleiterschalter, insbesondere Triac, der über einen als Berührungsschalter ausgebildeten Sensor zur Ein- und Ausschaltung der Last ansteuerbar ist, mit einer Stromversorgungsschaltung folgenden Aufbaus:
mit einem in Reihe zum steuerbaren Halbleiterschalter liegenden Spannungsbegrenzer-Zweipol, an dem bei leitendem steuerbaren Halbleiterschalter eine amplitudenbegrenzte Wechselspannung entsteht;
mit einem an den Spannungsbegrenzer-Zweipol angekoppelten induktiven Wandler;
mit einem dem induktiven Wandler nachgeschalteten Speicherkondensator, an dem eine auf einen Bezugspotentialpunkt bezogene Betriebsspannung für eine Steuerschaltung abnehmbar ist;
und mit einem der Reihenschaltung aus Spannungsbegrenzer-Zweipol und steuerbarem Halbleiterschalter parallel liegenden Zweig aus einer Reihenschaltung des Speicherkondensators und einem Gleichrichter; in dem im gesperrten Zustand des steuerbaren Halbleiterschalters an dem dann aus der vom Wechselspannungsnetz gelieferten Ausgangswechselspannung aufgeladenen Speicherkondensator die Betriebsspannung abnehmbar ist.

Damit bei Ein/Aus-Schaltern der vorstehend genannten Art die grösstmögliche Leistung an die Last abgegeben werden kann, darf durch den Schalter die Phase der aus dem Wechselspannungsnetz gelieferten Wechselspannung und des im eingeschalteten Zustand fliessenden Lastwechselstroms nicht angeschnitten werden. Darüber hinaus ist dies auch aus Störgründen wichtig, da sonst aufwendige Funk-Entstör-Bauelemente vorgesehen werden müssen.

Werden Ein/Aus-Schalter über Zweidraht-Leitungen angeschlossen, so steht am Einbauort nur ein Pol des Wechselspannungsnetzes zur Verfügung. In diesen Fällen ist die Verwendung von elektronischen Ein/Aus-Schaltern problematisch, da im eingeschalteten Zustand die Restspannung am steuerbaren Halbleiterschalter so klein ist, dass sie für eine Betriebsspannungsversorgung der Elektronik nicht ausreicht.

Aus der FR-A-2224942 ist eine Stromversorgungsschaltung für elektronisch steuerbare Unterbrecher mit den Merkmalen einer Stromversorgungsschaltung der im Oberbegriff des Anspruchs 1 angegebenen Art bekannt. Bei diesem bekannten elektronisch steuerbaren Unterbrecher sind aber weder Massnahmen zum Steuern eines steuerbaren Halbleiterschalters im gesperrten Zustand im Nulldurchgang der an ihm liegenden Spannung bzw. im leitenden Zustand im Nulldurchgang des ihn durchfliessenden Stroms realisiert. Bei gesperrtem steuerbaren Halbleiterschalter wird vielmehr nur eine Betriebsgleichspannung für eine Steuerelektronik erzeugt, ohne dass dabei Massnahmen vorhanden wären, den Nulldurchgang einer von einer Wechselspannungsquelle gelieferten Wechselspannung zu erkennen. Entsprechendes gilt bei durchgeschaltetem Halbleiterschalter für den Nulldurchgang des dann fliessenden Wechselstroms, da ebenfalls nur eine Betriebsgleichspannung für die Steuerelektronik erzeugt wird.

Der vorliegenden Erfindung liegt die Aufgabe zugrunde, einen elektronischen Sensor-Ein/Aus-Schalter der in Rede stehenden Art anzugeben, mit dem eine Ansteuerung des steuerbaren Halbleiterschalters sowohl im ausgeschalteten als auch im eingeschalteten Zustand in den Nulldurchgängen der Wechselspannung bzw. in den Nulldurchgängen des im eingeschalteten Zustand fliessenden Lastwechselstroms möglich ist.

Diese Aufgabe wird bei einem elektronischen Sensor-Ein/Aus-Schalter der eingangs genannten Art erfindungsgemäss durch folgende Merkmale gelöst:
Eine Steuerschaltung, durch die der steuerbare Halbleiterschalter im leitenden Zustand und damit bei eingeschalteter Last in den Nulldurchgängen eines dann fliessenden Laststroms mit einem ihn im leitenden Zustand haltenden Signal und/oder in gesperrtem Zustand und damit bei ausgeschalteter Last zu deren Einschaltung im Nulldurchgang der dann am Halbleiterschalter-Kreis stehenden Ausgangsspannung mit einem ihn in den leitenden Zustand schaltenden Signal ansteuerbar ist.

Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert. Es zeigt:
Fig. 1 eine Ausführungsform eines erfindungsgemässen elektronischen Sensor-Ein/Aus-Schalters;
Fig. 2A bis 2H jeweils ein Signaldiagramm zur Erläuterung der Wirkungsweise des elektronischen Sensor-Ein/Aus-Schalters nach Fig. 1;
Fig. 3 eine Ausführungsform einer Betriebsspannungsversorgungs-Schaltung für den elektronischen Sensor-Ein/Aus-Schalter nach Fig. 1;
Fig. 4A bis 4D jeweils ein Signaldiagramm zur Erläuterung der Wirkungsweise der Betriebsspannungsversorgungs-Schaltung nach Fig. 3 und eines Strom-Nulldurchgangsdetektors nach Fig. 10;
Fig. 5 bis 7 jeweils eine Ausführungsform eines induktiven Wandlers für die Betriebsspannungsversorgungs-Schaltung;
Fig. 8 eine Ausführungsform eines Spannungs-Nulldurchgangsdetektors für den erfindungsgemässen elektronischen Sensor-Ein/Aus-Schalter;
Fig. 9 Signaldiagramme zur Erläuterung der Wirkungsweise des Spannungs-Nulldurchgangsdetektors nach Fig. 8;
Fig. 10 eine Ausführungsform eines Strom-Nulldurchgangsdetektors für den erfindungsgemässen elektronischen Sensor-Ein/Aus-Schalter; und

Fig. 11 eine weitere Ausführungsform eines erfindungsgemässen elektronischen Sensor-Ein/Aus-Schalters.

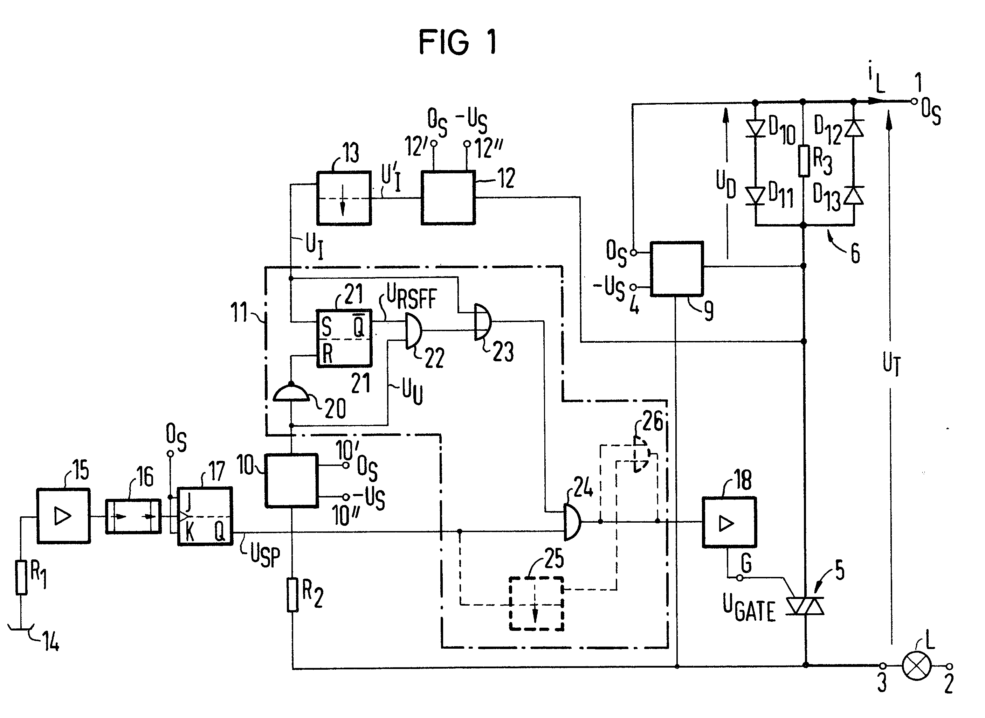

Anhand des Blockschaltbildes nach Fig. 1 sowie der Signaldiagramme nach den Fig. 2A bis 2H wird im folgenden eine erste Ausführungsform eines erfindungsgemässen elektronischen Sensor-Ein/Aus-Schalters beschrieben.

Gemäss dem Blockschaltbild nach Fig. 1 liegt an Klemmen 1 und 2 ein als Zweidraht-Leitung ausgebildetes Wechselspannungsnetz. An diesem Wechselspannungsnetz liegt in Reihe eine eine Last bildende Lampe L, ein steuerbarer Halbleiterschalter in Form eines Triac 5 und ein Spannungsbegrenzer-Zweipol 6. Dieser Spannungsbegrenzer-Zweipol 6 wird durch einen Widerstand $R_3$ sowie durch diesen Widerstand $R_3$ parallel und zueinander antiparallel liegenden Diodenzweige mit jeweils zwei in Reihe liegenden Dioden $D_{10}$, $D_{11}$ und $D_{12}$, $D_{13}$ gebildet. Bei gesperrtem Triac 5 fällt zwischen der Klemme 1 und einer Klemme 3 an der Reihenschaltung aus Spannungsbegrenzer-Zweipol 6 und Triac 5 eine Wechselspannung $U_T$ ab, während bei leitendem Triac 5 über die Reihenschaltung aus Spannungsbegrenzer-Zweipol 6, Triac 5 und Lampe L ein Laststrom $i_L$ fliesst. Wie anhand der Diagramme nach den Fig. 2A bis 2H im einzelnen noch erläutert wird, ist die Spannung $U_T$ auf ein Bezugspotential $O_S$ an der Klemme 1 bezogen, so dass die Klemme 3 als Ausgang des elektronischen Sensor-Ein/Aus-Schalters bezeichnet werden kann. Die Wechselspannung $U_T$ wird deshalb als Ausgangswechselspannung bezeichnet.

Wie bereits ausgeführt, ist es für die Funktion des elektronischen Sensor-Ein/Aus-Schalters wichtig, dass die Schaltvorgänge auf den Nulldurchgang der Spannung $U_T$ bzw. des Stromes $i_L$ bezogen werden. Zu diesem Zweck ist in der Schaltung nach Fig. 1 ein Spannungs-Nulldurchgangsdetektor 10 sowie ein Strom-Nulldurchgangsdetektor 12 vorgesehen. Der Spannungs-Nulldurchgangsdetektor 10 ist dabei über einen Widerstand $R_2$ an die Ausgangsklemme 3 angekoppelt, während der Strom-Nulldurchgangsdetektor 12 an den Spannungsbegrenzer-Zweipol 6 angekoppelt ist. Um die Stromversorgung sowohl im ausgeschalteten als auch im eingeschalteten Zustand sicherzustellen, ist erfindungsgemäss eine im folgenden noch genauer zu erläuternde Stromversorgungsschaltung 9 vorgesehen, welche eingangsseitig ebenfalls an den Spannungsbegrenzer-Zweipol 6 angekoppelt ist. Diese Stromversorgungsschaltung liefert an einer Ausgangsklemme 4 in im folgenden noch genauer zu beschreibender Weise eine Betriebsspannung $-U_S$. Eine weitere Ausgangsklemme der Stromversorgungsschaltung 9 liegt an der Klemme 1, so dass an dieser Ausgangsklemme der Stromversorgungsschaltung 9 das Bezugspotential $O_S$ zur Verfügung steht. Das Bezugspotential $O_S$ wird an einer Klemme 10' in den Spannungs-Nulldurchgangsdetektor 10 und an einer Klemme 12' in den Strom-Nulldurchgangsdetektor 12 eingegeben. Die Betriebsspannung $-U_S$ wird an einer Klemme 10'' in den Spannungs-Nulldurchgangsdetektor 10 und an einer Klemme 12'' in den Strom-Nulldurchgangsdetektor 12 eingegeben.

Zur Ansteuerung des Triac 5 an seinem Gate G mit einer Gatespannung $U_{GATE}$ werden die Ausgangssignale des Spannungs-Nulldurchgangsdetektors 10, des Strom-Nulldurchgangsdetektors 12 sowie ein Schaltsignal von einem Sensor 14 über eine Logik 11 miteinander verknüpft und über eine durch einen Verstärker gebildete Ausgangsstufe 18 in das Gate G des Triac 5 eingespeist. Dem Strom-Nulldurchgangsdetektor 12 ist dabei ein monostabiler Multivibrator 13 nachgeschaltet, über den eine vorgegebene Impulsdauer für die das Gate G des Triac 5 ansteuernden Impulse einstellbar ist.

Die Schaltsignale des Sensors 14 werden über einen Widerstand $R_1$, einen Vorverstärker 15 sowie ein Verzögerungsglied 16 auf ein Ein- und Aússchalt-JK-Flip-Flop 17 gegeben, dessen Ausgangssignal an einem Ausgang Q in die Logik 11 eingespeist wird. Das Verzögerungsglied dient zur Eliminierung von Schaltstörungen und besitzt eine Verzögerungszeit von beispielsweise etwa 0,06 sec.

Die Logik 11 enthält ein Flip-Flop 21, das an einem Setzeingang S vom Ausgangssignal $U_I$ des monostabilen Multivibrators 13 und an einem Rücksetzeingang R über einen Inverter 20 vom Ausgangssignal $U_U$ des Spannungs-Nulldurchgangsdetektors 10 angesteuert wird. Ein UND-Gatter 22 wird an einem Eingang durch ein Ausgangssignal $U_{RSFF}$ von einem komplementären Ausgang $\overline{Q}$ des Flip-Flops 21 und an einem weiteren Eingang vom Ausgangssignal des Spannungs-Nulldurchgangsdetektors 10 angesteuert. Der Ausgang des UND-Gatters 22 ist auf einen Eingang eines ODER-Gatters 23 geführt, das an einem weiteren Eingang vom Ausgangssignal $U_I$ des monostabilen Multivibrators 13 angesteuert wird. Der Ausgang des ODER-Gatters 23 ist auf einen Eingang eines weiteren UND-Gatters 24 geführt, das mit einem zweiten Eingang am Ausgang Q des Flip-Flops 17 liegt. Der Ausgang des UND-Gatters 24 ist über eine als Verstärker ausgebildete Ausgangsstufe 18 an das Gate G des Triac 5 gekoppelt.

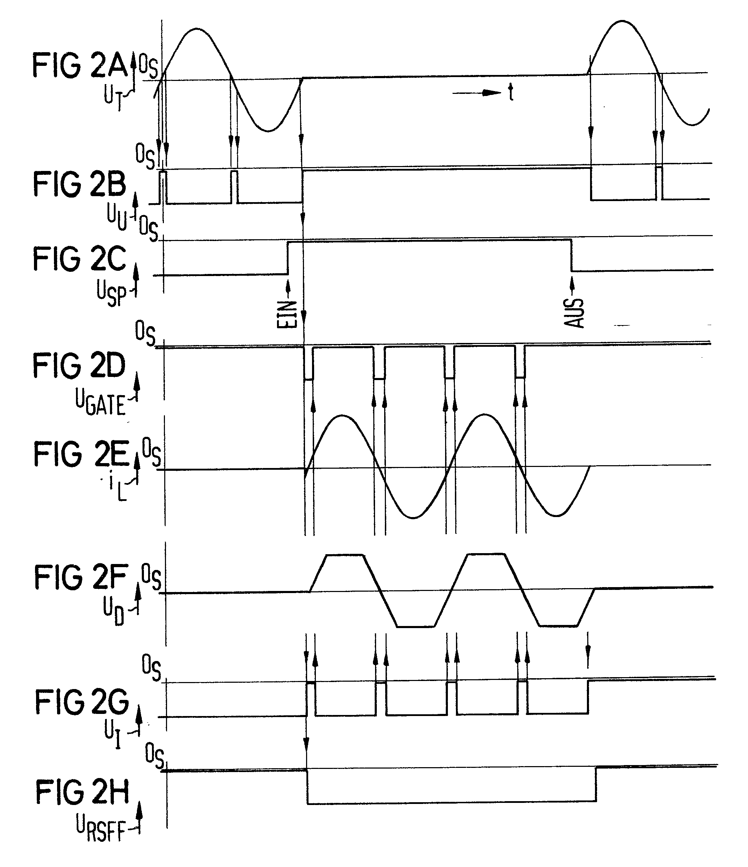

Die Wirkungsweise des vorstehend erläuterten elektronischen Sensor-Ein/Aus-Schalters ist die folgende: Es sei zunächst angenommen, dass vom Sensor 14 noch kein Einschaltsignal in die Schaltung eingegeben wird. Gemäss Fig. 2C steht dann das Flip-Flop 17 in einem Schaltzustand, in dem an seinem Ausgang Q ein Signal $U_{SP}$ mit tiefem Pegel abgegeben wird. Das UND-Gatter 24 in der Logik 11 ist daher gesperrt, so dass am Gate G des Triac 5 gemäss Fig. 2D eine auf Bezugspotential $O_S$ liegende Gate-Spannung $U_{GATE}$ steht. Der Triac 5 ist somit gesperrt. Damit fällt zwischen den Klemmen 1 und 3 gemäss Fig. 2A die Ausgangswechselspannung $U_T$ ab.

Der Spannungs-Nulldurchgangsdetektor 10 erzeugt gemäss Fig. 2B in den Nulldurchgängen der Spannung $U_T$ ein impulsförmiges Ausgangssignal $U_U$, das in den Nulldurchgängen von einem tiefen Pegel auf den Bezugspotenialpegel $O_S$ springt. Der Laststrom $i_L$ ist gemäss Fig. 2E gleich Null, so dass auch eine Spannung $U_D$ am Spannungsbegrenzer-Zweipol 6 gemäss Fig. 2F auf dem Bezugspegel $O_S$ liegt. Da damit auch die Ausgangsspannung $U'_I$ des Strom-Nulldurchgangsdetektors 12 auf tiefem Pegel liegt, erhält der monostabile Multivibrator 13 kein Ansteuersignal, so dass sein Ausgangssignal und damit das Ausgangssignal $U_I$ des monostabilen Multivibrators 13 gemäss Fig. 2G auf tiefem Pegel liegt. Das Flip-Flop 21 wird über das vom Inverter 20 invertierte impulsförmige Ausgangssignal $U_U$ des Spannungs-Nulldurchgangsdetektors 10 rückgesetzt, so dass an seinem Ausgang $\overline{Q}$ ein auf hohem Pegel (Bezugspotentialpegel $O_S$) ligendes Signal gemäss Fig. 2H steht.

Das UND-Gatter 22 ist daher wirksam geschaltet, so dass es das impulsförmige Ausgangssignal $U_U$ des Spannungs-Nulldurchgangsdetektors 10 auf das ODER-Gatter 23 überträgt, das seinerseits das Signal auf das UND-Gatter 24 überträgt. Da aber das Signal $U_{SP}$ am Ausgang Q des Flip-Flops 17 gemäss Fig. 2C auf tiefem Pegel liegt, bleibt das UND-Gatter 24 gesperrt, so dass das impulsförmige Ausgangssignal $U_U$ nicht auf das Gate G des Triac 5 übertragen werden kann.

Es sei nun angenommen, dass über den Sensor 14 in einem Zeitpunkt, der in Fig. 2C mit EIN bezeichnet ist, ein Einschaltsignal in die Schaltung eingegeben wird. Dieses Einschaltsignal wird in das Flip-Flop 17 übernommen, so dass das Signal $U_{SP}$ an seinem Ausgang Q auf einen hohen Pegel (Bezugspotentialpegel $O_S$) springt. Wie aus einem Vergleich der Fig. 2A und 2C zu ersehen ist, kann der Einschaltzeitpunkt in einem vom Nulldurchgang der Spannung $U_T$ verschiedenen Zeitpunkt liegen. Durch das nunmehr auf hohem Pegel liegende Ausgangssignal $U_{SP}$ des Flip-Flops 17 wird das UND-Gatter 24 aktiviert. Im nächsten auf den Einschaltzeitpunkt folgenden Nulldurchgang der Spannung $U_T$ springt das Ausgangssignal $U_U$ des Spannungs-Nulldurchgangsdetektors 10 auf einen hohen Pegel (Bezugspotentialpegel $O_S$), welcher nunmehr über das aktivierte UND-Gatter 24 auf das Gate G des Triac 5 übertragen wird, so dass dieser leitend geschaltet wird. Damit fliesst gemäss Fig. 2E Laststrom $i_L$ im Kreis zwischen den Klemmen 1 und 2 gemäss Fig. 1.

Aufgrund des nunmehr fliessenden Laststroms $i_L$ fällt am Spannungsbegrenzer-Zweipol 6 die Spannung $U_D$ ab. Aus dieser Spannung $U_D$ erzeugen der Strom-Nulldurchgangsdetektor 12 und der nachgeschaltete monostabile Multivibrator 13 ein impulsförmiges Signal $U_I$ gemäss Fig. 2G. Dieses Signal wird über das ODER-Gatter 23 und das durch das Einschaltsignal $U_{SP}$ gemäss Fig. 2C wirksam geschaltete UND-Gatter sowie die Ausgangsstufe 18 auf das Gate G des Triac 5 übertragen. Gleichzeitig wird das Flip-Flop 21 durch das in seinen Setzeingang eingespeiste Signal $U_I$ gesetzt, so dass das Signal $U_{RSFF}$ an seinem Ausgang $\overline{Q}$ gemäss Fig. 2H auf einen tiefen Pegel fällt und damit das UND-Gatter 22 gesperrt wird.

Da bei fliessendem Laststrom $i_L$ die Spannung $U_T$ gemäss Fig. 2A zu Null wird, liefert zwar der Spannungs-Nulldurchgangsdetektor 10 im eingeschalteten Zustand des Sensor-Ein/Aus-Schalters gemäss Fig. 2B ein konstant auf hohem Pegel liegendes Ausgangssignal $U_U$. Dieses Signal wird aber wegen des gesperrten UND-Gatters 22 nicht übertragen.

Wird in einem späteren, in Fig. 2C mit AUS bezeichneten Zeitpunkt durch erneutes Betätigen des Sensors 14 der Sensor-Ein/Aus-Schalter wieder ausgeschaltet, so treten gemäss den Fig. 2A bis 2H die Signalverhältnisse wieder ein, die oben bereits für den ausgeschalteten Zustand erläutert wurden.

Handelt es sich bei der Last L gemäss Fig. 1 um eine Leuchtstofflampe, so muss bis zum vollständigen Zünden einer solchen Leuchtstofflampe eine Kompensation vorgenommen werden, da bis zum Zündzeitpunkt nicht der volle Laststrom $i_L$ fliessen kann. Gemäss einer in Fig. 1 gestrichelt eingetragenen Variante ist für die Einschaltung derartiger Leuchtstofflampen in der Logik 11 eine zusätzliche Möglichkeit vorgesehen, um den Triac 5 für eine vorgegebene Anfangszeitperiode von beispielsweise einer Sekunde nach dem Einschalten kontinuierlich mit einer Gatespannung $U_{GATE}$ anzusteuern. Dazu ist an den Ausgang Q des Flip-Flops 17 ein monostabiler Multivibrator 25 angeschaltet, dessen Ausgang auf einen Eingang eines ODER-Gatters 26 geführt ist. Ein weiterer Eingang dieses ODER-Gatters 26 liegt am Ausgang des UND-Gatters 24. Der Ausgang des ODER-Gatters 26 ist über die Ausgangsstufe 18 an das Gate G des Triac 5 angekoppelt. Wird vom Sensor 14 über den Ausgang Q des Flip-Flops 17 ein Einschaltsignal geliefert, so liefert der monostabile Multivibrator 25 gemäss seiner für die vorgegebene Anfangszeitperiode gewählten Zeitkonstante an seinem Ausgang ein entsprechendes Signal, das über das ODER-Gatter 26 und die Ausgangsstufe 18 kontinuierlich in das Gate G des Triac 5 eingespeist wird. Damit wird der Triac 5 für die vorgegebene Anfangszeitperiode dauernd in seinem leitenden Zustand gehalten, bis die die Last L bildende Leuchtstofflampe voll gezündet hat.

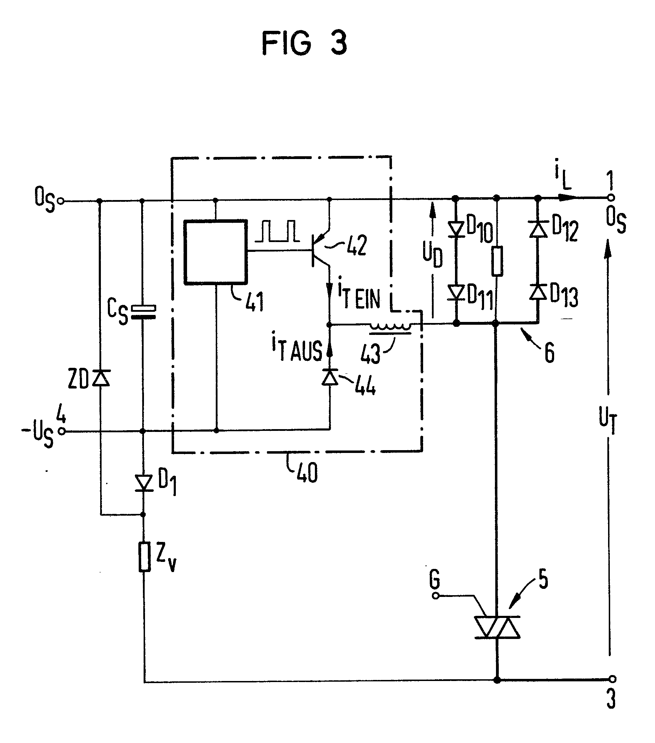

Im folgenden wird anhand von Fig. 3, in der gleiche Elemente wie in Fig. 1 mit gleichen Bezugszeichen versehen sind, die erfindungsgemässe Betriebsspannungsversorgung für die Elektronik des elektronischen Sensor-Ein/Aus-Schalters nach Fig. 1 beschrieben.

Es sei zunächst angenommen, dass der elektronische Sensor-Ein/Aus-Schalter ausgeschaltet ist, so dass zwischen den Klemmen 1 und 3 die Ausgangsspannung $U_T$ steht. Für diesen Fall ist in der Stromversorgungsschaltung 9 ein zwischen den Klemmen 1 und 3 liegender Zweig vorgesehen, welcher durch die Reihenschaltung eines Speicherkondensators $C_S$, einen Gleichrichter in Form einer Diode $D_1$ und einen Vorwiderstand $Z_V$ gebildet wird. Parallel zur Reihenschaltung aus Speicherkondensator $C_S$ und Diode $D_1$ liegt eine spannungsbegrenzende Zenerdiode ZD. Bei gesperr-

**0019813**

tem Triac 5 wird der Speicherkondensator $C_S$ aus der Ausgangsspannung $U_T$ aufgeladen, so dass an einem die Klemme 4 bildenden Verbindungspunkt zwischen dem Speicherkondensator $C_S$ und der Diode $D_1$ in bezug auf die den Bezugspotentialpunkt $O_S$ bildende Klemme 1 die Betriebsspannung $-U_S$ abnehmbar ist.

Der Vorwiderstand $Z_V$ dient zur Strombegrenzung und kann beispielsweise durch einen rein Ohmschen Widerstand oder durch ein RC-Glied gebildet werden.

Wird der Triac 5 im Sinne der Ausführungen zu der Schaltung nach Fig. 1 in den leitenden Zustand geschaltet, so fliesst der Laststrom $i_L$, wodurch am Spannungsbegrenzer-Zweipol 6 die Spannung $U_D$ abfällt. An den Spannungsbegrenzer-Zweipol 6 ist gemäss einer Ausführungsform der Erfindung ein induktiver Wandler in Form eines Drosselwandlers 40 angekoppelt. Dieser Drosselwandler enthält einen Impulsgenerator 41, der zwischen den Klemmen 1 und 4 an der Betriebsspannung $-U_S$ liegt. Der Impulsgenerator 41 kann beispielsweise durch einen an sich bekannten astabilen Multivibrator gebildet werden, der eine Impulsfolge mit vorgegebener Impulsfolgefrequenz liefert. An den Ausgang des Impulsgenerators 41 ist mit seiner Basis ein Schalter-Transistor 42 angekoppelt, der mit seinem Emitter an der Klemme 1 (Bezugspotentialpunkt $O_S$) und mit seinem Kollektor einerseits über eine Drossel 43 am Spannungsbegrenzer-Zweipol 6 und andererseits über eine Gleichrichterdiode 44 an der die Betriebsspannung $-U_S$ führenden Klemme 4 liegt. Die Gleichrichterdiode 44 liegt dabei mit ihrer Anode an der Klemme 4 und mit ihrer Kathode am Kollektor des SchalterTransistors 42.

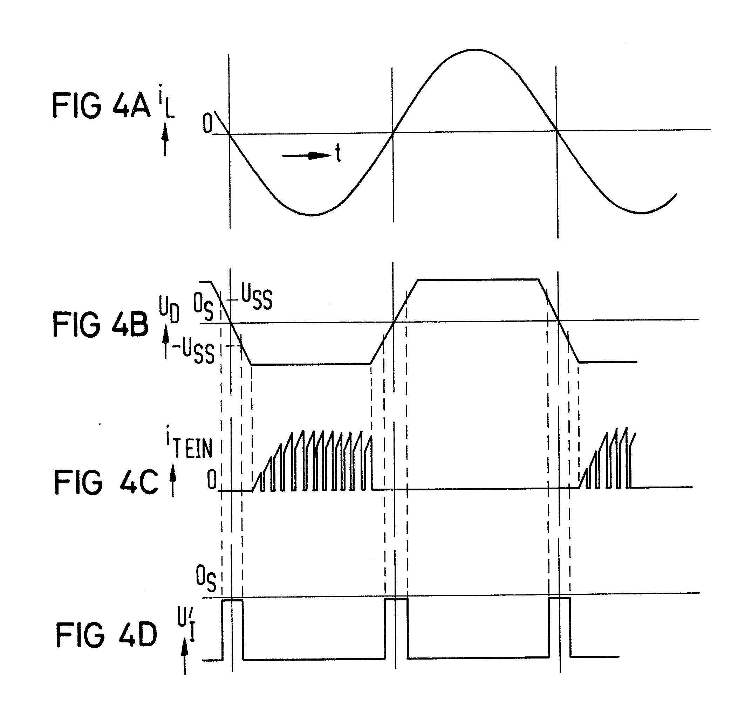

Die Wirkungsweise der vorstehend beschriebenen Betriebsspannungs-Versorgungsschaltung für den eingeschalteten Zustand des Sensor-Ein/ Aus-Schalters bei fliessendem Laststrom $i_L$ wird im folgenden anhand der Signaldiagramme nach den Figuren 4A bis 4C beschrieben. In Fig. 4A ist der Verlauf des Laststromes $i_L$ als Funktion der Zeit dargestellt. Mit zunehmendem Strom in der negativen Halbwelle des Laststroms $i_L$ fällt zunächst am Widerstand $R_3$ gemäss dem Diagramm nach Fig. 4B eine dem Strom porportionale Spannung ab, so dass die Spannung $U_D$ mit dem Laststrom ansteigt. Erreicht der Spannungsabfall am Widerstand $R_3$ die Summe der Schwellspannungen der Reihenschaltung der Dioden $D_{10}$ und $D_{11}$, welche dem Widerstand $R_3$ parallel liegen, so leiten diese Dioden voll, so dass die Spannung $U_D$ mit dem Laststrom $i_L$ nicht mehr weiter ansteigen kann und damit gemäss dem Diagramm nach Fig. 4B konstant bleibt.

Der Schalter-Transistor 42 wird an seiner Basis durch das impulsförmige Ausgangssignal des Impulsgenerators 41 abwechselnd durchgesteuert und gesperrt. So lange die Spannung $U_D$ (Fig. 4B) die Summe der Schwellspannungen der Diodenreihenschaltungen noch nicht erreicht hat, kann im durchgeschalteten Zustand des Transistors 42 über diesen noch kein Strom fliessen, da die Diodenreihenschaltungen dann noch nicht leiten. Hat jedoch die Spannung $U_D$ die Summe der Schwellspannungen der Reihenschaltung aus zwei Dioden erreicht, so kann bei durchgeschaltetem Transistor 42 im Kreis aus diesem Transistor, der Drossel 43 und der Reihenschaltung zweier Dioden Strom fliessen. In der negativen Halbwelle des Laststroms $i_L$ ist der Verbindungspunkt zwischen Drossel 43 und Spannungsbegrenzer-Zweipol 6 in bezug auf die Klemme 1 (Bezugspotentialpunkt $O_S$) negativ. Bei durchgeschaltetem Transistor 42 kann dann über dessen Emitter-Kollektorstrecke die Drossel 43 und die Reihenschaltung der Dioden $D_{10}$ und $D_{11}$ Strom fliessen, wodurch magnetische Energie in der Drossel gespeichert wird. Dieser Strom ist in Fig. 3 und im Diagramm nach Fig. 4C mit $i_{TEIN}$ bezeichnet. Aus Fig. 4C ist ersichtlich, dass dieser Strom $i_{TEIN}$ gemäss den Ein- und Ausschaltzeiten des Schalter-Transistors 42 einen impulsförmigen Verlauf besitzt, wobei sich in den Einschaltzeiten des Schalter-Transistors 42 entsprechend der in der Drossel 43 bereits gespeicherten Energie einem Anfangswert eine sägezahnförmige Spitze überlagert. In den Ausschaltzeiten des Schalter-Transistors 42 fliesst aufgrund der in der Drossel 43 gespeicherten Energie ein Strom im Kreis aus Drossel 43, den Dioden $D_{10}$ und $D_{11}$, dem Speicherkondensator $C_S$ und der Gleichrichterdiode 44, welcher in Fig. 3 mit $i_{TAUS}$ bezeichnet ist. Dieser Strom $i_{TAUS}$, welcher aus der in der Drossel 43 gespeicherten Energie geliefert wird, lädt den Speicherkondensator $C_S$ auf, so dass an der Klemme 4 im eingeschalteten Zustand des Sensor-Ein/Aus-Schalters die Betriebsspannung $-U_S$ aus der Ladespannung des Speicherkondensators $C_S$ abgenommen werden kann.

In der positiven Halbwelle des Laststroms $i_L$ gemäss Fig. 4A kehrt sich die Polarität der Spannung $U_D$ gemäss dem Diagramm nach Fig. 4B um. Da nunmehr der Verbindungspunkt zwischen der Drossel 43 und dem Spannungsbegrenzer-Zweipol 6 gegenüber der Klemme 1 (Bezugspotentialpunkt $O_S$) positiv wird, kann über den SchalterTransistor 42 kein Strom fliessen, d. h., der Strom $i_{TEIN}$ gemäss Fig. 4C ist gleich Null.

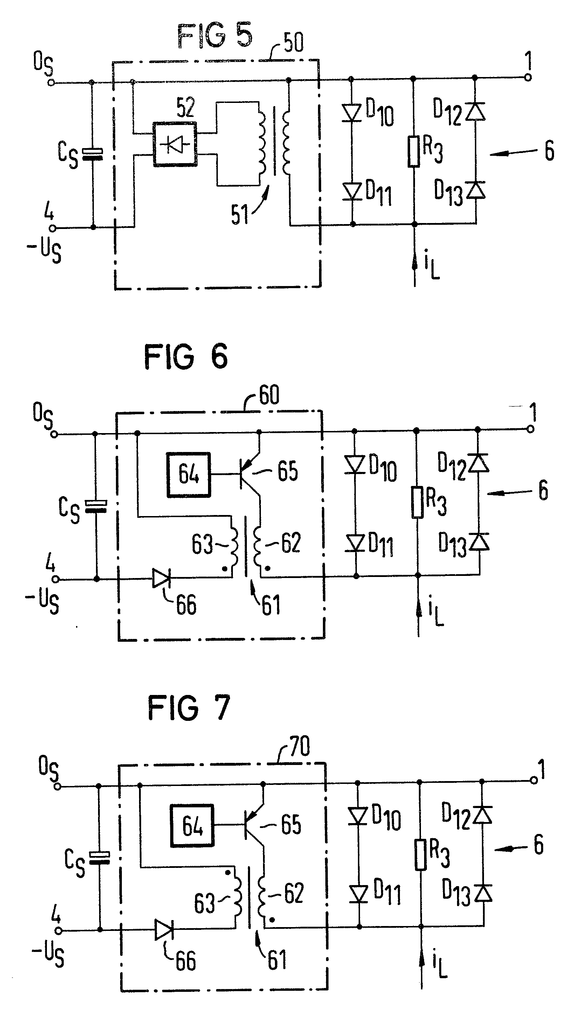

Anstelle des vorstehend beschriebenen Drosselwandlers in der Stromversorgungsschaltung nach Fig. 3 können gemäss weiterer Ausführungsformen der Erfindung auch andere induktive Wandler verwendet werden. Derartige Ausführungsformen sind in den Fig. 5 bis 7 dargestellt, in denen gleiche Elemente wie in den Fig. 1 und 3 mit gleichen Bezugszeichen versehen sind.

Fig. 5 zeigt eine Ausführungsform, bei der an den Spannungsbegrenzer-Zweipol 6 ein induktiver Wandler 50 mit einem für Netzfrequenz ausgelegten Transformator 51 angekoppelt ist, an dessen nicht eigens bezeichneter Sekundärwicklung ein Gleichrichter 52 liegt. Das Ausgangssignal dieses Gleichrichters 52 lädt den Speicherkondensator $C_S$ zur Erzeugung der Betriebsspannung $-U_S$ auf.

Fig. 6 zeigt eine Ausführungsform mit einem am Spannungsbegrenzer-Zweipol 6 liegenden induktiven Wandler in Form eines Flusswandlers 60. Dieser Flusswandler 60 enthält einen Transformator 61 mit einer Primärwicklung 62 und einer Sekundärwicklung 63, wobei der Wicklungssinn dieser beiden Wicklungen durch Punkte angedeutet ist. Im Kreis der Primärwicklung 62 liegt ein Schalter-Transistor 65, der ebenso wie der Schalter-Transistor 42 nach Fig. 3 durch einen Impulsgenerator 64 angesteuert wird. Im Kreis der Sekundärwicklung 63 liegt eine Gleichrichterdiode 66, über die der Speicherkondensator $C_S$ zur Erzeugung der Betriebsspannung $-U_S$ aufgeladen wird.

Fig. 7 zeigt eine Ausführungsform mit einem am Spannungsbegrenzer-Zweipol 6 liegenden induktiven Wandler 70 in Form eines Sperrwandlers, welcher die gleichen Komponenten wie der Flusswandler nach Fig. 6 aufweist. Bei diesem Sperrwandler ist jedoch der Wicklungssinn der Sekundärwicklung 63 des Transformators 61 im Vergleich zum Wicklungssinn der Sekundärwicklung 63 nach Fig. 6 gegensinnig ausgeführt.

Da Flusswandler und Sperrwandler der vorstehend skizzierten Art an sich bekannte Schaltungen darstellen, wird hier auf ihre Wirkungsweise nicht näher eingegangen.

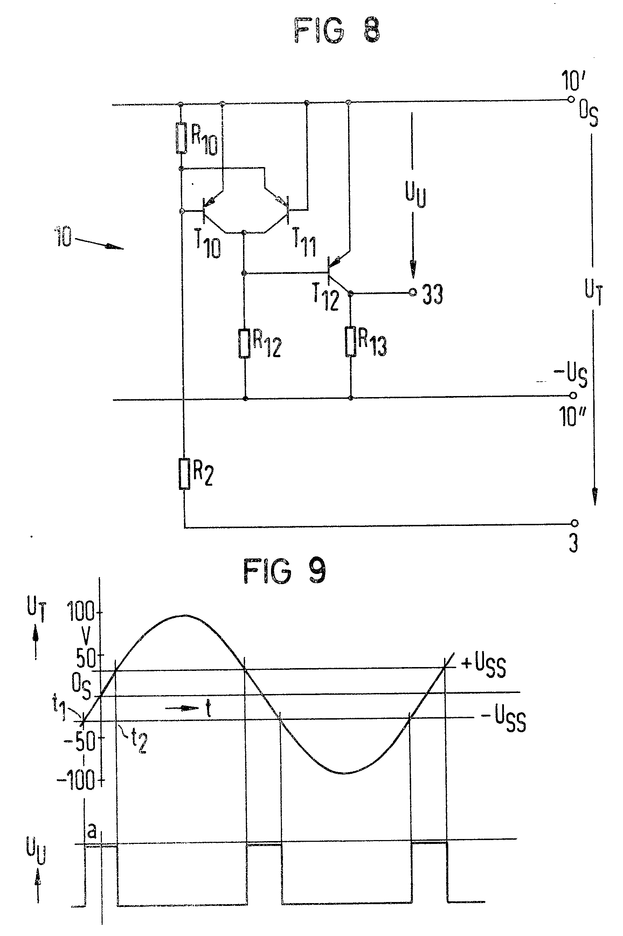

Im folgenden wird anhand von Fig. 8 eine Ausführungsform des Spannungs-Nulldurchgangsdetektors 10 nach Fig. 1 beschrieben.

Zwischen den Klemmen 10' und 3 dieses Spannungs-Nulldurchgangsdetektors steht die bereits anhand der Fig. 1 und 2A bis 2H erläuterte Ausgangswechselspannung $U_T$. An der Klemme 10" wird die Betriebsspannung $-U_S$ eingespeist. Der Spannungs-Nulldurchgangsdetektor enthält zwei Transistoren $T_{10}$ und $T_{11}$, die mit ihren Kollektoren direkt zusammengeschaltet und über einen Arbeitswiderstand $R_{12}$ an der Betriebsspannung $-U_S$ liegen. Der Emitter des Transistors $T_{10}$ und die Basis des Transistors $T_{11}$ sind direkt an die das Bezugspotential $O_S$ führende Klemme 10' angeschaltet. Die Basis des Transistors $T_{10}$ und der Emitter des Transistors $T_{11}$ liegen am Abgriff eines Spannungsteilers, der aus einem Widerstand $R_{10}$ und dem bereits anhand von Fig. 1 erwähnten Widerstand $R_2$ gebildet wird. Dieser Spannungsteiler liegt zwischen der Klemme 10' und der Ausgangsklemme 3.

Ein Ausgangstransistor $T_{12}$ liegt mit seiner Basis am Verbindungspunkt der Kollektoren der Transistoren $T_{10}$ und $T_{11}$ sowie des Arbeitswiderstandes $R_{12}$. Der Emitter des Transistors $T_{12}$ liegt direkt an der Bezugspotential $O_S$ führenden Klemme 10', während sein Kollektor über einen Arbeitswiderstand $R_{13}$ an der die Beriebsspannung $-U_S$ führenden Klemme 10" liegt. Der Verbindungspunkt des Kollektors des Transistors $T_{12}$ und des Arbeitswiderstandes $R_{13}$ bildet einen Ausgang 30 des Spannungs-Nulldurchgangsdetektors, wobei zwischen der Klemme 10' und diesem Ausgang 30 das impulsförmige Ausgangssignal $U_U$ des Spannungs-Nulldurchgangsdetektors 10 abnehmbar ist.

Die Wirkungsweise dieser Ausführungsform des Spannungs-Nulldurchgangsdetektors wird anhand des Diagramms nach Fig. 9 erläutert, das in seinem oberen Teil die sinusförmig verlaufende Ausgangswechselspannung $U_T$ an der Ausgangsklemme 3, bezogen auf das Bezugspotential $O_S$ an der Klemme 10' als Funktion der Zeit und im unteren Teil das impulsförmige Ausgangssignal $U_U$ als Funktion der Zeit zeigt.

Es sei zunächst angenommen, dass die Ausgangsspannung $U_T$ in ihrer negativen Halbwelle grösser als eine Schwellspannung $-U_{SS}$ ist. Für diese Werte der Ausgangsspannung $U_T$ ist der Transistor $T_{10}$ voll durchgesteuert, so dass sein Kollektor praktisch auf Bezugspotential $O_S$ an der Klemme 10' liegt, während der Transistor $T_{11}$ gesperrt ist, weil sein Emitter auf dem gleichen negativen Potential wie die Basis des Transistors $T_{10}$ liegt. Da die Basis des Transistors $T_{12}$ über den voll durchgesteuerten Transistor $T_{10}$ praktisch auf Bezugspotential $O_S$ an der Klemme 10' liegt, ist der Transistor $T_{12}$ gesperrt, so dass an ihm praktisch die gesamte Betriebsspannung $-U_S$ abfällt. Damit liegt das Ausgangssignal $U_U$ gemäss dem unteren Diagramm nach Fig. 9 auf einem negativen (tiefen) Pegel.

Erreicht nun die Ausgangsspannung $U_T$ gemäss dem oberen Diagramm nach Fig. 9 in einem Zeitpunkt $t_1$ in ihrer negativen Halbwelle den negativen Schwellwert $-U_{SS}$, so wird der Transistor $T_{10}$ gesperrt, wobei auch der Transistor $T_{11}$ noch gesperrt bleibt, weil sein Emitter relativ zum Bezugspotenial $O_S$ an der Klemme 10' noch auf negativerem Potential liegt. Der Transistor $T_{12}$ kann nunmehr über seine Emitter-Basis-Strecke und den Widerstand $R_{12}$ Strom ziehen, so dass er voll durchgesteuert wird. Sein Kollektorpotential wird damit gleich dem Bezugspotential $O_S$ an der Klemme 10', so dass das Ausgangssignal $U_U$ gemäss dem unteren Diagramm nach Fig. 4 auf den Bezugspotentialpunkt $O_S$ springt.

Erreicht die Spannung $U_T$ in ihrer positiven Halbwelle in einem Zeitpunkt $t_2$ einen positiven Schwellwert $+U_{SS}$, so wird der Emitter des Transistors $T_{11}$ positiver als die an Bezugspotential $O_S$ an der Klemme 10' liegende Basis, so dass der Transistor $T_{11}$ durchgesteuert wird. Der Transistor $T_{10}$ bleibt gesperrt, weil seine Basis auf positiverem Potential als sein Emitter liegt. Aufgrund des durchgeschalteten Transistors $T_{11}$ wird nunmehr die Basis des Transistors $T_{12}$ wieder auf Bezugspotential $O_S$ gezogen, so dass dieser Transistor wieder gesperrt und die Ausgangsspannung $U_U$ wiederum auf den negativen (tiefen) Pegel springt.

Der Vorgang wiederholt sich entsprechend in allen Nulldurchgängen der Ausgangsspannung $U_T$.

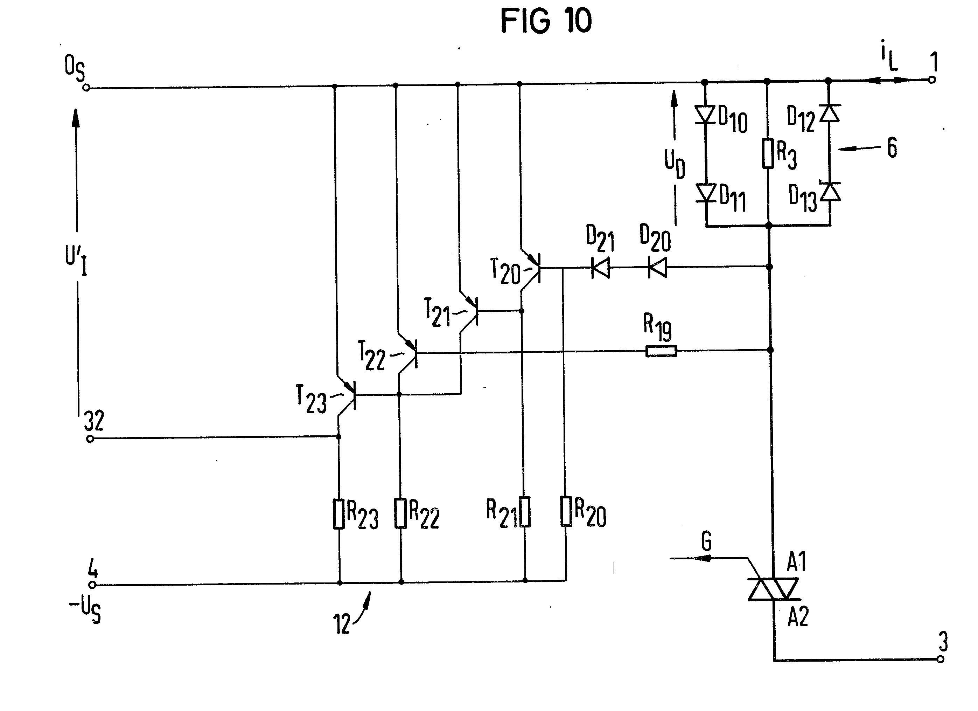

Im folgenden wird anhand der Fig. 4A bis 4D und 10 eine Ausführungsform des Strom-Nulldurchgangsdetektors 12 nach Fig. 1 beschrieben. Für die Erläuterung der Wirkungsweise dieses Strom-Nulldurchgangsdetektors sind in Fig. 10 der Lastkreis mit Triac 5 und Spannungsbegrenzer-Zweipol 6 noch einmal mit dargestellt.

Der Strom-Nulldurchgangsdetektor liegt über die Reihenschaltung zweier Dioden $D_{20}$ und $D_{21}$ sowie über einen Widerstand $R_{19}$ am Spannungsbegrenzer-Zweipol 6. Die Dioden $D_{20}$ und $D_{21}$ sind auf die Basis eines Transistors $T_{20}$ geführt, wobei

**0019813**

die Basis dieses Transistors weiterhin über einen Widerstand $R_{20}$ an der Betriebsspannung $-U_S$ (Klemme 4) liegt. Der Emitter dieses Transistors $T_{20}$ liegt direkt am Bezugspotentialpunkt $O_S$ (Klemme 1), während sein Kollektor über einen Widerstand $R_{21}$ an der Betriebsspannung $-U_S$ (Klemme 4) liegt. Dem Transistor $T_{20}$ ist ein Transistor $T_{21}$ nachgeschaltet, der mit seiner Basis am Verbindungspunkt des Kollektors des Transistors $T_{20}$ und des Widerstandes $R_{21}$, mit seinem Emitter direkt an Bezugspotential $O_S$ (Klemme 1) und mit seinem Kollektor über einen Widerstand $R_{22}$ an der Betriebsspannung $U_S$ (Klemme 4) liegt. Der Widerstand $R_{19}$ ist auf die Basis eines Transistors $T_{22}$ geführt, dessen Emitter an Bezugspotential $O_S$ (Klemme 1) und dessen Kollektor am Verbindungspunkt des Kollektors des Transistors $T_{21}$ und des Widerstandes $R_{22}$ liegt. Dem Transistor $T_{22}$ ist ein Transistor $T_{23}$ nachgeschaltet, dessen Basis am Verbindungspunkt des Kollektors des Transistors $T_{22}$ und des Widerstandes $R_{22}$, dessen Emitter an Bezugspotential $O_S$ (Klemme 1) und dessen Kollektor über einen Widerstand $R_{23}$ an der Betriebsspannung $-U_S$ (Klemme 4) liegt. An einem Ausgang 32 des Strom-Nulldurchgangsdetektors 12 ist in bezug auf die Klemme 1 (Bezugspotential $O_S$) des Ausgangssignals $U'_I$ abnehmbar.

Die Wirkungsweise des vorstehend beschriebenen Strom-Nulldurchgangsdetektors wird in Verbindung mit dem Signaldiagramm nach den Fig. 4A bis 4D beschrieben. Es sei zunächst angenommen, dass die Spannung $U_D$ nach Fig. 4B ihren maximalen positiven Wert besitzt. Diese positive Spannung wird über die Dioden $D_{20}$ und $D_{21}$ auf die Basis des Transistors $T_{20}$ und über den Widerstand $R_{19}$ auf die Basis des Transistors $T_{22}$ übertragen. Damit sind diese Transistoren gesperrt. Bei gesperrtem Transistor $T_{20}$ kann der Transistor $T_{21}$ über seine Emitter-Basis-Strecke und den Widerstand $R_{21}$ Basisstrom ziehen, sodass er in den voll durchgesteuerten Zustand durchgeschaltet wird. Damit liegt die Basis des Transistors $T_{23}$ praktisch auf Bezugspotential $O_S$, so dass dieser Transistor gesperrt ist. Es fällt somit praktisch die gesamte Betriebsspannung $-U_S$ an der Emitter-Kollektor-Strecke des Transistors $T_{23}$ ab, sodass der Ausgang 32 praktisch auf der Betriebsspannung $-U_S$ liegt. Das Ausgangssignal $U'_I$ liegt daher gemäss Fig. 4D auf tiefem Pegel. Es sei nun die fallende Flanke der Spannung $U_D$ gemäss Fig. 4B betrachtet, mit der diese Spannung im Nulldurchgang des Laststromes $i_L$ von ihrem maximalen positiven auf ihren maximalen negativen Wert fällt. Im noch positiven Bereich erreicht die Spannung $U_D$ gemäss Fig. 4B einen Schwellwert $+U_{SS}$, der nicht mehr ausreicht, um den Transistor $T_{20}$ über die Dioden $D_{20}$ und $D_{21}$ im gesperrten Zustand zu halten. Dieser positive Schwellwert $+U_{SS}$ ist über die Summe der Schwellspannungen der Dioden $D_{20}$ und $D_{21}$ definiert. Nunmehr kann der Transistor $T_{20}$ über seine Emitter-Basis-Strecke und den Widerstand $R_{20}$ Basisstrom ziehen, so dass er voll durchgesteuert wird. Da die Spannung $U_D$ jedoch noch positiv ist, bleibt der Transistor $T_{22}$ gesperrt. Bei durchgesteuertem Transistor $T_{20}$ wird der

Transistor $T_{21}$ gesperrt, da seine Basis über die Emitter-Kollektor-Strecke des Transistors $T_{20}$ praktisch auf Bezugspotential $O_S$ liegt. Da auch der Transistor $T_{22}$ noch gesperrt ist, kann der Transistor $T_{23}$ über seine Emitter-Basis-Strecke und den Widerstand $R_{22}$ Strom ziehen, so dass er voll durchgesteuert wird. Damit springt das Ausgangssignal $U'_I$ gemäss Fig. 4D praktisch auf Bezugspotential $O_S$.

Erreicht die Spannung $U_D$ einen negativen Schwellwert $-U_{SS}$, welcher durch den Widerstand $R_{19}$ festgelegt ist, so erhält der Transistor $T_{22}$ Basisstrom, so dass er durchgesteuert wird. Damit wird der Transistor $T_{23}$ wiederum gesperrt, da seine Basis nunmehr über die Emitter-Kollektor-Strecke des durchgesteuerten Transistors $T_{22}$ auf Bezugspotential $O_S$ liegt. Gemäss Fig. 4D springt damit das Ausgangssignal $U'_I$ wieder auf den durch die Betriebsspannung $-U_S$ festgelegten tiefen Pegel.

Die vorstehend erläuterten Vorgänge wiederholen sich entsprechend auch für den Verlauf der Spannung $U_D$ gemäss Fig. 4B von ihrem maximalen negativen Wert zu ihrem maximalen positiven Wert. Der Strom-Nulldurchgangsdetektor gemäss Fig. 10 liefert daher das impulsförmige Ausgangssignal $U'_I$ gemäss Fig. 4D.

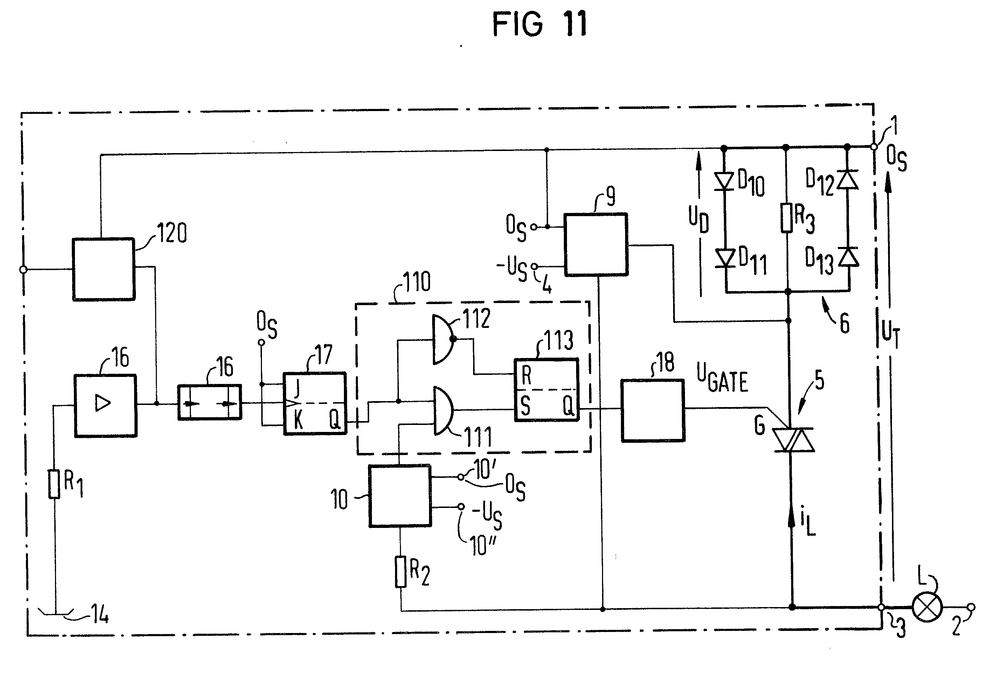

Fig. 11, in der gleiche Elemente wie in Fig. 1 mit gleichen Bezugszeichen versehen sind, zeigt eine weitere Ausführungsform des erfindungsgemässen Sensor-Ein/Aus-Schalters gemäss der Erfindung. Hinsichtlich der bereits anhand von Fig. 1 erläuterten Komponenten des Sensor-Ein/Aus-Schalters wird auf die Ausführung zu Fig. 1 verwiesen.

Bei der Ausführungsform nach Fig. 11 wird das Gate G des Triacs 5 mit einem Dauersignal $U_{GATE}$ angesteuert. Zu diesem Zweck enthält eine Logik 110 ein UND-Gatter 111, das mit einem Eingang an den Ausgang des bereits erläuterten Spannungs-Nulldurchgangsdetektors 10 und mit einem weiteren Eingang an das bereits erläuterte Flip-Flop 17 angeschaltet ist. Der Ausgang des Flip-Flops 17 ist weiterhin über einen Inverter 112 an einen Rücksetzeingang R eines Flip-Flops 113 angekoppelt, während der Ausgang des UND-Gatters 111 an einen Setzeingang S des Flip-Flops 113 angekoppelt ist. Ein Ausgang Q des Flip-Flops 113 ist über die bereits erläuterte Ausgangsstufe 18 an das Gate G des Triacs 5 angekoppelt.

Wird der Sensor 14 zur Einschaltung betätigt, so wird das Flip-Flop gesetzt und liefert an seinem Ausgang Q ein Ausgangssignal, wodurch das UND-Gatter 111 wirksam geschaltet wird. Im nächsten Nulldurchgang der Spannung $U_T$ zwischen den Klemmen 1 und 3 liefert der Spannungs-Nulldurchgangsdetektor 10 in der anhand der Fig. 1, 3 und 4 erläuterten Weise ein impulsförmiges Ausgangssignal, das über das UND-Gatter 111 auf den Setzeingang S des Flip-Flops 113 übertragen wird, wodurch dieses Flip-Flop gesetzt wird. Das dann an seinem Ausgang Q stehende Ausgangssignal wird über die Ausgangsstufe auf das Gate G des Triacs 5 übertragen. Dieser Schaltzustand wird so lange kontinuierlich aufrechterhalten, bis der Sensor 14 zur Ausschaltung der Last L erneut betätigt wird. Dabei wird dann das Flip-Flop 17 rückgesetzt, so dass sein Ausgang Q auf einen tiefen Pegel fällt. Dieser tiefe Pegel wird durch den Inverter 112 invertiert, so dass das Flip-Flop 113 rückgesetzt wird, d. h., der Ausgang Q dieses Flip-Flops fällt auf einen tiefen Pegel, so dass das Steuersignal $U_{GATE}$ am Gate G des Triacs 5 verschwindet, wodurch der Triac gesperrt und die Last ausgeschaltet wird.

Soll der Sensor-Ein/Aus-Schalter auch noch von einer anderen Stelle aus (Nebenstelle) geschaltet werden können, so kann ein Nebenstelleneingang 120 vorgesehen werden, welcher vor dem Verzögerungsglied 16 in den Gesamtkreis eingeschaltet ist. Über einen dem Sensor 14 entsprechenden Sensor kann der Ein/Aus-Schalter dann auch noch von einer anderen Stelle ein- und ausgeschaltet werden.

### Patentansprüche

1. Elektronischer Sensor-Ein/Aus-Schalter für eine an einem insbesondere als Zweidraht-Leitung ausgebildeten Wechselspannungsnetz liegende Last (L) mit einem in Reihe zur Last liegenden steuerbaren Halbleiterschalter (5), insbesondere Triac, der über einen als Berührungsschalter ausgebildeten Sensor (14) zur Ein- und Ausschaltung der Last (L) ansteuerbar ist, mit einer Stromversorgungsschaltung (9) folgenden Aufbaus: mit einem in Reihe zum steuerbaren Halbleiterschalter (5) liegenden Spannungsbegrenzer-Zweipol (6), an dem bei leitendem steuerbaren Halbleiterschalter (5) eine amplitudenbegrenzte Wechselspannung ($U_D$) entsteht; mit einem an den Spannungsbegrenzer-Zweipol (6) angekoppelten induktiven Wandler (40; 50; 60; 70); mit einem dem induktiven Wandler nachgeschalteten Speicherkondensator ($C_S$), an dem eine auf einem Bezugspotentialpunkt ($O_S$) bezogene Betriebsspannung ($-U_S$) für eine Steuerschaltung abnehmbar ist; und mit einem der Reihenschaltung aus Spannungsbegrenzer-Zweipol (6) und steuerbarem Halbleiterschalter (5) parallel liegenden Zweig aus einer Reihenschaltung des Speicherkondensators ($C_S$) und einem Gleichrichter ($D_1$); in dem im gesperrten Zustand des steuerbaren Halbleiterschalters (5) an dem dann aus der vom Wechselspannungsnetz gelieferten Ausgangswechselspannung ($U_T$) aufgeladenen Speicherkondensator ($C_S$) die Betriebsspannung ($-U_S$) abnehmbar ist, gekennzeichnet durch eine Steuerschaltung (10, 11, 12; 10, 110), durch die der steuerbare Halbleiterschalter (5) im leitenden Zustand und damit bei eingeschalteter Last (L) in den Nulldurchgängen eines dann fliessenden Laststroms ($i_L$) mit einem ihn im leitenden Zustand haltenden Signal und/oder in gesperrtem Zustand und damit bei ausgeschalteter Last (L) zu deren Einschaltung im Nulldurchgang der dann am Halbleiterschalter-Kreis stehenden Ausgangsspannung ($U_T$) mit einem ihn in den leitenden Zustand schaltenden Signal ansteuerbar ist.

2. Elektronischer Sensor-Ein/Aus-Schalter nach Anspruch 1, dadurch gekennzeichnet, dass der Spannungsbegrenzer-Zweipol (6) durch einen ohmschen Widerstand ($R_3$) und zwei diesem parallel und zueinander antiparallel liegenden Gleichrichter ($D_{10}$, $D_{11}$ und $D_{12}$, $D_{13}$) gebildet ist.

3. Elektronischer Sensor-Ein/Aus-Schalter nach Anspruch 2, dadurch gekennzeichnet, dass die dem Widerstand ($R_3$) parallel und zueinander antiparallel liegenden Gleichrichter durch jeweils eine oder mehrere in Reihe liegende Dioden ($D_{10}$, $D_{11}$ bzw. $D_{12}$, $D_{13}$) gebildet sind.

4. Elektronischer Sensor-Ein/Aus-Schalter nach einem der Ansprüche 1 bis 3, dadurch gekennzeichnet, dass der induktive Wandler durch einen Drosselwandler (40) gebildet ist.

5. Elektronischer Sensor-Ein/Aus-Schalter nach Anspruch 4, dadurch gekennzeichnet, dass der Drosselwandler (40) folgende Komponenten enthält: einen Impulsgenerator (41) mit im Vergleich zur halben Netzfrequenz grosser Pulsfolgefrequenz, einen vom Impulsgenerator (41) gesteuerten Halbleiterschalter (42), insbesondere Transistor, dessen gesteuerte Strecke in Reihe mit einer Drosselspule (43) dem Spannungsbegrenzer-Zweipol (6) parallel liegt, und eine mit ihrer Anode an einer die Betriebsspannung ($-U_S$) führenden Klemme (4) des Speicherkondensators ($C_S$) und mit ihrer Kathode im Verbindungspunkt der gesteuerten Strecke des Halbleiterschalters (42) und der Drosselspule (43) liegende Gleichrichterdiode (44).

6. Elektronischer Sensor-Ein/Aus-Schalter nach einem der Ansprüche 1 bis 3, dadurch gekennzeichnet, dass der induktive Wandler (50) durch einen Netztransformator (51) mit nachgeschaltetem Gleichrichter (52) gebildet ist.

7. Elektronischer Sensor-Ein/Aus-Schalter nach einem der Ansprüche 1 bis 3, dadurch gekennzeichnet, dass der induktive Wandler (60) durch einen Flusswandler (61, 62, 63, 64, 65, 66) gebildet ist.

8. Elektronischer Sensor-Ein/Aus-Schalter nach einem der Ansprüche 1 bis 3, dadurch gekennzeichnet, dass der induktive Wandler (70) durch einen Sperrwandler (61, 62, 63, 64, 65, 66) gebildet ist.

9. Elektronischer Sensor-Ein/Aus-Schalter nach einem der Ansprüche 1 bis 8, dadurch gekennzeichnet, dass die Steuerschaltung (10, 11, 12) einen Spannungs-Nulldurchgangsdetektor (10), welcher bei gesperrtem steuerbarem Halbleiterschalter (5) und damit ausgeschalteter Last (L) als Funktion der Nulldurchgänge der Ausgangswechselspannung ($U_T$) ein impulsförmiges Ausgangssignal ($U_U$) abgibt, eine durch ein Einschaltsignal vom Sensor (14) und vom impulsförmigen Ausgangssignal ($U_U$) des Spannungs-Nulldurchgangsdetektors (10) wirksam geschaltete Logik (11) zur Einspeisung des impulsförmigen Ausgangssignals des Spannungs-Nulldurchgangsdetektors (10) in eine Steuerelektrode (G) des steuerbaren Halbleiterschalters (5), und einen an den Spannungsbegrenzer-Zweipol (6) angekoppelten Strom-Nulldurchgangsdetektors (12), die Spannung ($U_D$) am Spannungsbegrenzer-Zweipol (6) in ein impulsförmiges Ausgangssignal (U'ı) überführt, enthält, wobei die Logik (11, 110) den Spannungs-Nulldurchgangsdetektor (10) bei leitendem steuerbarem Halbleiterschalter (5) von der Steuerelektrode (G) des steuerbaren Halbleiterschalters (5) abkoppelt und das impulsförmige Ausgangssignal (U'ı) des Strom-Nulldurchgangsdetektors (12) auf die Steuerelektrode (G) des steuerbaren Halbleiterschalters (5) koppelt.

10. Elektronischer Sensor-Ein/Aus-Schalter nach einem der Ansprüche 1 bis 9, gekennzeichnet durch einen Spannungs-Nulldurchgangsdetektor (10) folgender Ausbildung: einen ersten Transistor ($T_{10}$), der mit seinem Emitter am Bezugspotentialpunkt ($O_S$) der Ausgangswechselspannung ($U_T$), mit seinem Kollektor über einen Arbeitswiderstand ($R_{12}$) an der Betriebsspannung ($-U_S$) und mit seiner Basis am Abgriff eines an der Ausgangswechselspannung ($U_T$) liegenden Spannungsteilers ($R_{10}$, $R_2$) liegt, einen zweiten Transistor ($T_{11}$), der mit seinem Emitter am Abgriff des Spannungsteilers ($R_{10}$, $T_2$), mit seinem Kollektor über den Arbeitswiderstand ($R_{12}$) an der Betriebsspannung ($-U_S$) und mit seiner Basis am Bezugspotentialpunkt ($O_S$) der Ausgangswechselspannung ($U_T$) liegt, und einen dritten Transistor ($T_{12}$), der mit seinem Emitter am Bezugspotentialpunkt ($O_S$) der Ausgangswechselspannung ($U_T$), mit seinem Kollektor über einen weiteren Arbeitswiderstand ($R_{13}$) an der Betriebsspannung ($-U_S$) und mit seiner Basis am Verbindugspunkt der Kollektoren des ersten und zweiten Transistors ($T_{10}$, $T_{11}$) und deren Arbeitswiderstand ($R_{12}$) liegt, wobei der Spannungsteiler ($R_{10}$, $R_2$) so dimensioniert ist, dass der erste und zweite Transistor ($T_{10}$, $T_{11}$) bei einem vorgegebenen negativen bzw. positiven Wert im Bereich des Nulldurchgangs der Ausgangswechselspannung ($U_T$) durchgeschaltet werden und wobei das impulsförmige Ausgangssignal ($U_U$) zwischen dem Bezugspotentialpunkt ($O_S$) der Ausgangswechselspannung ($U_T$) und dem Kollektor des dritten Transistors ($T_{12}$) abnehmbar ist.

11. Elektronischer Sensor-Ein/Aus-Schalter nach einem der Ansprüche 1 bis 10, gekennzeichnet durch einen Strom-Nulldurchgangsdetektor (12) folgender Ausbildung: einem ersten Transistor ($T_{20}$), dessen Basis über mindestens eine gegen die Durchlassrichtung der Basis-Emitter-Strecke dieses Transistors ($T_{20}$) geschaltete Diode ($D_{20}$, $D_{21}$) am Spannungsbegrenzer-Zweipol (6) und über einen ersten Widerstand ($R_{20}$) an der Betriebsspannung ($-U_S$), dessen Emitter am Bezugspotentialpunkt ($O_S$) und dessen Kollektor über einen zweiten Widerstand ($R_{21}$) an der Betriebsspannung ($-U_S$) liegt, einen zweiten Transistor ($T_{21}$), dessen Basis am Kollektor des ersten Transistors ($T_{20}$) und über den zweiten Widerstand ($R_{21}$) an der Betriebsspannung ($-U_S$), dessen Emitter am Bezugspotentialpunkt ($O_S$) und dessen Kollektor über einen dritten Widerstand ($R_{22}$) an der Betriebsspannung ($-U_S$) liegt, einen dritten Transistor ($T_{22}$), dessen Basis über einen vierten Widerstand ($R_{19}$) am Spannungsbegrenzer-Zweipol (6), dessen Emitter am Bezugspotentialpunkt

($O_S$) und dessen Kollektor am Kollektor des zweiten Transistors (21) und über den dritten Widerstand ($R_{22}$) an der Betriebsspannung ($-U_S$) liegt, und einen vierten Transistor ($T_{23}$), dessen Basis am Kollektor des dritten Transistors ($T_{22}$), dessen Emitter am Bezugspotentialpunkt ($O_S$) und dessen Kollektor über einen fünften Widerstand ($R_{33}$) an der Betriebsspannung ($-U_S$) liegt, wobei das impulsförmige Ausgangssignal ($U'_ı$) zwischen dem Kollektor des vierten Transistors ($T_{22}$) und Bezugspotentialpunkt ($O_S$) abnehmbar ist.

12. Elektronischer Sensor-Ein/Aus-Schalter nach einem der Ansprüche 1 und 9 bis 11, dadurch gekennzeichnet, dass der Strom-Nulldurchgangsdetektor (12) zur Einstellung einer vorgegebenen Impulsdauer seines impulsförmigen Ausgangssignals ($U'_ı$) über einen monostabilen Multivibrator (13) an die Logik (11) angekoppelt ist.

13. Elektronischer Sensor-Ein/Aus-Schalter nach einem der Ansprüche 1 und 9 bis 12, gekennzeichnet durch eine Logik (11) folgender Ausbildung: ein Flip-Flop (21), das mit seinem Setzeingang (S) an den Ausgang des monostabilen Multivibrators (13) und mit seinem Rücksetzungseingang (R) über einen Inverter (20) an den Ausgang des Spannungs-Nulldurchgangsdetektors (10) angekoppelt ist, ein erstes UND-Gatter (22), das mit einem Eingang an einen komplementären Ausgang ($\overline{Q}$) des Flip-Flops (21) und mit einem weiteren Eingang an den Ausgang des Spannungs-Nulldurchgangsdetektors (10) angekoppelt ist, ein ODER-Gatter (23), das mit einem Eingang an den Ausgang des ersten UND-Gatters (22) und mit einem weiteren Eingang an den Ausgang des monostabilen Multivibrators (13) angekoppelt ist, und ein zweites UND-Gatter (24), das mit einem Eingang an den Ausgang des ODER-Gatters (23) mit einem weiteren Eingang an den Sensor (14) und mit seinem Ausgang an die Steuerelektrode (G) des steuerbaren Halbleiterschalters (5) angekoppelt ist.

14. Elektronischer Sensor-Ein/Aus-Schalter nach Anspruch 13, dadurch gekennzeichnet, dass der Sensor (14) über einen Vorverstärker (15) und ein Verzögerungsglied (16) auf den Steuereingang eines Ein/Aus-Flip-Flops (17) gekoppelt ist, dessen Ausgang an den weiteren Eingang des zweiten UND-Gatters (24) der Logik (11) geschaltet ist.

15. Elektronischer Sensor-Ein/Aus-Schalter nach Anspruch 14, dadurch gekennzeichnet, dass die Logik (11) weiterhin einen vom Ausgang des Ein/Aus-Flip-Flops (17) angesteuerten monostabilen Multivibrators (25) sowie ein zweites ODER-Gatter (26) enthält, und dass der Ausgang des monostabilen Multivibrators (25) an einem Eingang des zweiten ODER-Gatters (26), der Ausgang des zweiten UND-Gatters (24) an einen weiteren Eingang des zweiten ODER-Gatters (26) und der Ausgang des zweiten ODER-Gatters (26) an die Steuerelektrode (G) des steuerbaren Halbleiterschalters (5) angekoppelt ist.

16. Elektronischer Sensor-Ein/Aus-Schalter nach einem der Ansprüche 1 bis 8 und 10 bis 11, dadurch gekennzeichnet, dass die Steuerschaltung (110) einen Spannungs-Nulldurchgangsdetektor (10), welcher bei gesperrtem steuerbarem Halbleiterschalter (5) und damit ausgeschalteter Last (L) als Funktion der Nulldurchgänge der Ausgangswechselspannung ($U_T$) ein impulsförmiges Ausgangssignal ($U_U$) abgibt, und eine durch ein Einschaltsignal vom Sensor (14) und vom impulsförmigen Ausgangssignal ($U_U$) des Spannungs-Nulldurchgangsdetektors (10) wirksam geschaltete Logik (110) zur Einspeisung des impulsförmigen Ausgangssignals des Spannungs-Nulldurchgangsdetektors (10) in die Steuerelektrode (G) des steuerbaren Halbleiterschalters (5), aufweist, und dass die Logik (110) ein UND-Gatter (111), das mit einem Eingang an den Ausgang des Spannungs-Nulldurchgangsdetektors (10) und mit einem weiteren Eingang an den Sensor (14) angekoppelt ist, einen Inverter (112), der mit seinem Eingang an den Sensor (14) angekoppelt ist, und ein Flip-Flop (113), das mit einem Setzeingang (S) an den Ausgang des UND-Gatters (111), mit einem Rücksetzeingang (R) an den Ausgang des Inverters (112) und mit einem durch ein Signal an seinem Setzeingang (S) wirksam geschalteten Ausgang (Q) an die Steuerelektrode (G) des steuerbaren Halbleiterschalters (5) umfasst.

**Claims**

1. An electronic sensor on/off-switch for a load (L) connected to an alternating voltage network, in particular a two-wire line, having a controllable semiconductor switch (5), in particular a triac, series-connected to the load and driven by means of a sensor (14) a contact switch to connect and disconnect the load (L), and having a current supply circuit (9) of the following construction: a voltage limiting two-pole (6) connected in series with the controllable semiconductor switch (5) at which an amplitude-limited alternating voltage ($U_D$) occurs in the case of a conductive controllable semiconductor switch (5); an inductive converter (40; 50; 60; 70) coupled to the voltage limiting two-pole (6); a storage capacitor ($C_S$) connected following the inductive converter from which an operating voltage ($-U_S$) related to a reference potential point ($O_S$) can be tapped for a control circuit; and a branch which consists of a series connection of the storage capacitor ($C_S$) and a rectifier ($D_1$) arranged parallel to the series connection composed of the voltage limiting two-pole (6) and the controllable semiconductor switch (5); wherein in the blocked state of the controllable semiconductor switch (5), the operating voltage ($-U_S$) can be tapped at the storage capacitor ($C_S$) which is then charged from the output alternating voltage ($U_T$) supplied by the alternating voltage network, characterised by a control circuit (10, 11, 12; 10, 110), by which in the conductive state when the load (L) is connected in the zero passages of a currently flowing load current ($i_L$), the controllable semiconductor switch (5) can be driven by means of a signal which retains the semiconductor switch in the conductive state, and/or in the blocked state when the load (L) is disconnected to connect the latter at a zero passage of the output voltage ($U_T$) which then occurs at the semiconductor switch circuit, the controllable semiconductor switch can be driven by means of a signal which switches it into the conductive state.

2. An electronic sensor on/off-switch as claimed in Claim 1, characterised in that the voltage limiting two-pole (6) is formed by a resistor ($R_3$) and two rectifiers ($D_{10}$, $D_{11}$ and $D_{12}$, $D_{13}$) arranged parallel to said resistor and anti-parallel to one another.

3. An electronic sensor on/off-switch as claimed in Claim 2, characterised in that the rectifiers arranged parallel to the resistor ($R_3$) and anti-parallel to one another are respectively formed by one or more diodes ($D_{10}$, $D_{11}$ and $D_{12}$, $D_{13}$) arranged in series.

4. An electronic sensor on/off-switch as claimed in one of Claims 1 to 3, characterised in that the inductive converter is formed by a choke converter (40).

5. An electronic sensor on/off-switch as claimed in Claim 4, characterised in that the choke converter (40) includes the following components: a pulse generator (41) having a pulse train frequency large compared with half the network frequency, a semiconductor switch (42), in particular a transistor controlled by the pulse generator (31) and whose controlled section in series with a choke coil (43) is arranged to the voltage limiting two-pole (6), and a rectifier diode (44) which has its anode arranged at a terminal (4) of the storage capacitor ($C_S$) which carries the operating voltage ($-U_S$), and has its cathode arranged at the conection point of the controlled path of the semiconductor switch (42) and the choke coil (43).

6. An electronic sensor on/off-switch as claimed in one of Claims 1 to 3, characterised in that the inductive converter (50) is formed by a network transformer (51) with a following rectifier (52).

7. An electronic sensor on/off-switch as claimed in one of Claims 1 to 3, characterised in that the inductive converter (60) is formed by a flow converter (61, 62, 63, 64, 65, 66).

8. An electronic sensor on/off-switch as claimed in one of Claims 1 to 3, characterised in that the inductive converter (70) is formed by a blocking converter (61, 62, 63, 64, 65, 66).

9. An electronic sensor on/off-switch as claimed in one of Claims 1 to 8, characterised in that the control circuit (10, 11, 12) comprises a voltage zero passage detector (10) which emits a pulse-shaped output signal ($U_U$) as a function of the zero passages of the alternating output voltage ($U_T$) when the controllable semi-conductor switch (5) is blocked and the load (L) is consequently disconnected; a logic circuit (11), which is switched so as to be effective by a starting signal from the sensor (14) and the pulse-shaped output signal ($U_U$) of the voltage zero passage detector (10), for feeding the pulse-shaped output signal of the voltage zero passage detector (10) to a control electrode (G) of the controllable semiconductor switch (5); and a current zero passage detector (12) coupled to the voltage limiting two-pole (6) to transfer the voltage ($U_D$) at the voltage limiting two-pole (6) into a pulse-shaped output signal ($U'_I$) where the logic circuit (11, 10) decouples the voltage zero passage detector (10) from the control electrode (G) of the controllable semiconductor switch (5) while the controllable semiconductor switch (5) is conductive and couples the pulse-shaped output signal ($U'_I$) of the current zero passage detector (12) to the control electrode (G) of the controllable semiconductor switch (5).

10. An electronic sensor on/off-switch as claimed in one of Claims 1 to 9, characterised by a voltage zero passage detector (10) of the following construction: a first transistor ($T_{10}$) which has its emitter arranged at the reference potential point ($O_S$) of the alternating output voltage ($U_T$), its collector connected to the operating voltage ($-U_S$) by an operating resistor ($R_{12}$) and its base connected to the tap of a voltage divider ($R_{10}$, $R_2$) arranged at the alternating output voltage ($U_T$), a second transistor ($T_{11}$) which has its emitter connected to the tap of the voltage divider ($R_{10}$, $R_2$), its collector to the operating voltage ($-U_S$) by the operating resistor ($R_{12}$) and its base to the reference potential point ($O_S$) of the alternating output voltage ($U_T$), and a third transistor ($T_{12}$) which has its emitter connected to the reference potential point ($O_S$) of the alternating output voltage ($U_T$), its collector to the operating voltage ($-U_S$) by a further operating resistor ($R_{13}$) and its base to the connection point of the collector of the first and second transistors ($T_{10}$, $T_{11}$) and the operation resistor ($R_{12}$) thereof, where the voltage divider ($R_{10}$, $R_2$) is so dimensioned that the first and second transistor ($R_{10}$, $R_{11}$) are switched through in the region of the zero passage of the alternating output voltage ($U_T$) in the case of a predetermined negative or positive value, as the case may be, and where the pulse-shaped output signal ($U_U$) can be tapped between the reference potential point ($O_S$) of the alternating output voltage ($U_T$) and the collector of the third transistor ($T_{12}$).

11. An electronic sensor on/off-switch as claimed in one of Claims 1 to 10, characterised by a current zero passage detector (12) of the following construction: a first transistor ($T_{20}$), whose base is connected to the voltage limiting two-pole (6) by at least one diode ($D_{20}$, $D_{21}$) poled against the transmission direction of the base-emitter-path of this transistor ($T_{20}$) and connected to the reference voltage ($-U_S$) by means of a first resistor ($R_{20}$), whose emitter is connected to the reference potential point ($O_S$) and whose collector is connected to the operating voltage ($-U_S$) by a second resistor ($R_{21}$), a second transistor ($T_{21}$) whose base is connected to the collector of the first transistor ($T_{20}$) and to the operating voltage ($-U_S$) by the second resistor ($R_{21}$), whose emitter is connected to the reference potential point ($O_S$) and whose collector is connected to the operating potential ($-U_S$) by a third resistor ($R_{22}$), a third transistor ($T_{22}$), whose base is connected to the voltage limiting two-pole (6) by a further resistor ($R_{19}$), whose emitter is connected to the reference potential

point ($O_S$), and whose collector is connected to the collector of the second transistor (21) and to the operating voltage ($-U_S$) by the third resistor ($R_{22}$), and a fourth transistor ($T_{23}$), whose base is connected to the collector of the third transistor ($T_{22}$), whose emitter is connected to the reference potential point ($O_S$) and whose collector is connected to the operating voltage ($-U_S$) by a fifth resistor ($R_{33}$), where the pulse-shaped output signal ($U'_I$) can be tapped between the collector of the fourth transistor ($T_{22}$) and the reference potential point ($O_S$).

12. An electronic sensor on/off-switch as claimed in one of Claims 1 and 9 to 11, characterised in that the current zero detector (12) is coupled to the logic circuit (11) by a mono-stable multivibrator (13) in order to adjust a predetermined pulse duration of its pulse-shaped output signal ($U'_I$).

13. An electronic sensor on/off-switch as claimed in one of Claims 1 and 9 to 12, characterised by a logic circuit (11) of the following construction: a flip-flop (21) which has its setting input (S) connected to the output of the mono-stable multivibrator (13) and its re-setting input (R) to the output of the voltage zero passage detector (10) by an inverter (20), a first AND-gate (22) which has one input connected to a complementary output ($\overline{Q}$) of the flip-flop (21) and a further input to the output of the voltage zero passage detector (10), an OR-gate (23) which has one input connected to the output of the first AND-gate (22) and a further input to the output of the monostable multivibrator (13), and a second AND-gate (24) which has one input connected to the output of the OR-gate (23), a further input to the sensor (14) and its output to the control electrode (G) of the controllable semi-conductor switch (5).

14. An electronic sensor on/off-switch as claimed in Claim 13, characterised in that the sensor (14) is coupled to the control input of an on/off flip-flop (17) by a pre-amplifier (15) and a delay element (16), the output of which on/off flip-flop is connected to the further input of the second AND-gate (24) of the logic circuit (11).

15. An electronic sensor on/off-switch as claimed in Claim 14, characterised in that the logic circuit (11) further comprises a monostable multivibrator (25) controlled by the output of the on/off flip-flop (17), and comprises a second OR-gate (26), and that the output of the monostable multivibrator (25) is coupled to an input of the second OR-gate (26), the output of the second AND-gate (24) is connected to a further input of the second OR-gate (26) and the output of the second OR-gate (26) is coupled to the control electrode (G) of the controllable semiconductor switch (5).

16. An electronic sensor on/off-switch as claimed in one of Claims 1 to 8 and 10 to 11, characterised in that the control circuit (110) has a voltage zero passage detector (10) which emits a pulse-shaped output signal ($U_U$) as a function of the zero passages of the alternating output voltage ($U_T$) when the semiconductor switch (5) is blocked and the load (L) is therefore disconnected, and has a logic circuit (110) switched to be effective by means of a starting signal from the sensor (14) and the pulse-shaped output signal ($U_U$) of the voltage zero passage detector (10) and which serves to feed the pulse-shaped output signal of the voltage zero passage detector (10) to the control electrode (G) of the controllable semiconductor switch (5), and that the logic (110) comprises and AND-gate (111) which has one input connected to the output of the voltage zero passage detector (10) and a further input to the sensor (14), and comprises an inverter (112) which has its input connected to the sensor (14), and comprises a flip-flop (113) which has a setting input (S) connected to the output of the AND-gate (111), a resetting input (R) to the output of the inverter (112) and an output (Q), its setting input (S) being switched to be effective by a signal, connected to the control electrode (G) of the controllable semiconductor switch (5).

## Revendications

1. Commutateur électronique marche-arrêt à effleurement pour une charge (L) reliée à un réseau de tension alternative réalisé en particulier sous la forme d'un conducteur bifilaire, avec un commutateur à semiconducteurs contrôlable (5) en série avec la charge, en particulier un triac qui est susceptible d'être contrôlé par le branchement et le débranchement de la charge, par l'intermédiaire d'un détecteur (14) réalisé sous la forme d'un commutateur à effleurement, avec un circuit d'alimentation en courant (9) ayant la constitution suivante: avec un dipôle à limitation de tension (6), monté en série avec le commutateur à semiconducteurs contrôlable (5) et au niveau duquel se forme, lorsque le commutateur à semiconducteurs contrôlable (5) est passant, une tension alternative ($U_D$) d'amplitude limitée; avec un convertisseur inductif (40; 50; 60; 70) couplé au dipôle à limitation de tension (6); avec un condensateur de mémorisation ($C_S$) monté en aval du convertisseur inductif et aux bornes duquel peut être prélevée, pour un circuit de commande, une tension de fonctionnement ($-U_S$) rapportée à un point de potentiel de référence; et avec une branche montée en parallèle sur le circuit série constitué par le dipôle à limitation de tension (6) et par le commutateur à semiconducteurs contrôlable (5) et formée par un circuit série constitué par le condensateur de mémorisation ($C_S$) et par un redresseur ($D_1$); dans lequel, lorsque le commutateur à semiconducteurs contrôlable (5) est dans son état bloqué, on peut prélever la tension de fonctionnement ($-U_S$) aux bornes du condensateur ($C_S$) chargé alors par la tension alternative de sortie ($U_T$) fournie par le réseau de tension alternative, caractérisé par un circuit de commande (10, 11, 12; 10, 110) à l'aide duquel le commutateur à semiconducteurs contrôlable (5) est susceptible d'être commandé dans l'état conducteur et, par voie de conséquence, lorsque la charge (L) est branchée, dans les passages par la valeur nulle d'un courant de charge ($I_L$) qui passe alors, avec un signal que le maintient à l'état passant et/ou à l'état bloqué est par voie de conséquence, lorsque la charge (L) est débranchée, pour le branchement de celle-ci au passage par la valeur nulle de la tension de sortie ($U_T$) disponible au niveau du circuit à semiconducteurs, avec un signal le commutant dans l'état conducteur.

2. Commutateur électronique marche-arrêt à effleurement selon la revendication 1, caractérisé par le fait que le dipôle à limitation de tension (6) est formé par une résistance ohmique ($R_3$) et par deux redresseurs ($D_{10}$, $D_{11}$ et $D_{12}$, $D_{13}$) montés en anti-parallèle entre eux et en parallèle à ladite résistance ohmique.

3. Commutateur électronique marche-arrêt à effleurement selon la revendication 2, caractérisé par le fait que les redresseurs qui sont montés en parallèle à la résistance ($R_3$) et qui sont en montage anti-parallèle entre eux, sont respectivement formés par une ou plusieurs diodes en série ($D_{10}$, $D_{11}$ ou $D_{12}$, $D_{13}$).

4. Commutateur électronique marche-arrêt à effleurement selon l'une des revendications 1 à 3, caractérisé par le fait que le convertisseur inductif est constitué par un convertisseur à inductance (40).

5. Commutateur électronique marche-arrêt à effleurement selon la revendication 4, caractérisé par le fait que le convertisseur à inductance (40) comporte les éléments suivants: un générateur d'impulsions (41) à fréquence de répétition des impulsions importante par rapport à la moitié de la fréquence du réseau, un commutateur à semiconducteurs (42) contrôlé par le générateur d'impulsions (41), en particulier un transistor dont la voie contrôlée, en série avec une bobine de self (43), est montée en parallèle sur le dipôle à limitation de tension (6), et avec une diode redresseuse (44) qui est reliée par son anode à une borne (4) du condensateur de mémorisation qui est à la tension de fonctionnement ($-U_S$) et dont la cathode est reliée au point de liaison de la voie contrôlée du commutateur à semiconducteurs (42) et de la bobine de self (43).

6. Commutateur électronique marche-arrêt à effleurement selon l'une des revendications 1 à 3, caractérisé par le fait que le convertisseur inductif (50) est formé par un transformateur de réseau (51) avec redresseur aval (52).

7. Commutateur électronique marche-arrêt à effleurement selon l'une des revendications 1 à 3, caractérisé par le fait que le convertisseur inductif (60) est constitué par un convertisseur de flux (61, 62, 63, 64, 65, 66).

8. Commutateur électronique marche-arrêt à effleurement selon l'une des revendications 1 à 3, caractérisé par le fait que le convertisseur inductif (70) est constitué par un convertisseur à oscillateur bloqué (61, 62, 63, 64, 65, 66).

9. Commutateur électronique marche-arrêt à effleurement selon l'une des revendications 1 à 8, caractérisé par le fait que le circuit de commande (10, 11, 12) comporte un détecteur pour le passage à la valeur nulle de la tension (10) qui, lorsque le commutateur à semiconducteurs contrôlable (5) est bloqué et que de ce fait la charge (L) est débranchée, émet, en tant que fonction des passages par la valeur nulle de la tension alternative de sortie ($U_T$), un signal de sortie de forme impulsionnelle ($U_U$), un circuit logique (11) commuté dans son état actif par un signal de branchement du détecteur (14) et du signal de sortie de forme impulsionnelle ($U_U$) du détecteur de passage par la valeur nulle de la tension (10), en vue de mémoriser le signal de sortie de forme impulsionnelle du détecteur de passage par la valeur nulle de la tension (10) dans une électrode de commande (G) du commutateur à semiconducteurs contrôlable (5), et un détecteur de passage pour la valeur nulle du courant (12), couplé au dipôle à limitation de tension (6), et qui transforme la tension ($U_D$) au niveau du dipôle à limitation de tension (6), en un signal de sortie de forme impulsionnelle ($U'_D$), la réalisation étant telle que le circuit logique (11, 110) débranche le détecteur du passage par la valeur nulle de la tension (10), lorsque le commutateur à semiconducteurs contrôlable (5) est dans son état passant, de l'électrode de commande (G) du commutateur à semiconducteurs contrôlable (5) et applique le signal de sortie de forme impulsionnelle ($U'_I$) du détecteur de passage par la valeur nulle du courant (10), à l'électrode de commande (G) du commutateur à semiconducteurs contrôlable (5).

10. Commutateur électronique marche-arrêt à effleurement selon l'une des revendications 1 à 9, caractétérisé par un détecteur de passage par la valeur nulle de la tension (10) de conformation suivante: un premier transistor ($T_{10}$) dont l'émetteur est relié au point de potentiel de référence ($O_S$) de la tension alternative de sortie, dont le collecteur est relié, par l'intermédiaire d'une résistance de charge ($R_{12}$) à la tension de fonctionnement (−$U_S$) et dont la base est reliée à la prise d'un diviseur de tension ($R_{10}$, $R_2$) qui est relié à la tension alternative de sortie ($U_T$), un second transistor ($T_{11}$) dont l'émetteur est relié à la prise du diviseur de tension ($R_{10}$, $R_2$) dont le collecteur est relié, par l'intermédiaire d'une résistance de charge ($R_{12}$), à la tension de fonctionnement (−$U_S$) et dont la base est reliée au point de potentiel de référence ($O_S$) de la tension alternative de sortie ($U_T$), et un troisième transistor ($T_{12}$) dont l'émetteur est relié au point de potentiel de référence ($O_S$) de la tension alternative de sortie ($U_T$) dont le collecteur est relié par l'intermédiaire d'une autre résistance de charge ($R_{13}$), à la tension de fonctionnement (−$U_S$) et dont la base est reliée au point de liaison des collecteurs du premier et du second transistors ($T_{10}$, $T_{11}$) et leur résistance de charge ($R_{12}$) le diviseur de tension ($R_{10}$, $R_2$) étant dimensionné de telle façon que le premier et le second transistors ($T_{10}$, $T_{11}$), et pour une valeur négative ou positive prédéterminée de la tension alternative de sortie ($U_T$), dans le voisinage du passage pour la valeur zéro, sont commandés dans leur état passant, alors que le signal de sortie de forme impulsionnelle ($U_U$) est susceptible d'être prélevé entre le point de potentiel de référence ($O_S$) de la tension alternative de sortie ($U_T$) et le collecteur du troisième transistor ($T_{12}$).

11. Commutateur électronique marche-arrêt à effleurement selon l'une des revendications 1 à 10, caractérisé par un détecteur de passage par la valeur nulle du courant (12), de constitution suivante: un premier transistor ($T_{20}$) dont la base est reliée, par l'intermédiaire d'une diode ($D_{20}$, $D_{21}$) qui est montée en opposition au sens passant du circuit base-émetteur de ce transistor ($T_{20}$), au dipôle à limitation de tension (6) et, par l'intermédiaire d'une première résistance ($R_{20}$) à la tension de fonctionnement (−$U_S$), dont l'émetteur est relié au point de potentiel de référence ($O_S$) et dont le collecteur est relié par l'intermédiaire d'une seconde résistance ($R_{21}$), à la tension de fonctionnement (−$U_S$), un second transistor ($T_{21}$) dont la base est reliée au collecteur du premier transistor ($T_{20}$) et, par l'intermédiaire de la seconde résistance ($R_{21}$), à la tension de fonctionnement (−$U_S$), dont l'émetteur est relié au point de potentiel de référence ($O_S$) et dont le collecteur est relié, par l'intermédiaire d'une troisième résistance ($R_{22}$), à la tension de fonctionnement (−$U_S$), un troisième transistor ($T_{22}$), dont la base est reliée, par l'intermédiaire d'une quatrième résistance ($R_{19}$), au dipôle à limitation de tension (6) dont l'émetteur est relié au point de potentiel de référence ($O_S$) et dont le collecteur est relié au collecteur du second transistor (21) et, par l'intermédiaire de la troisième résistance ($R_{22}$), à la tension de fonctionnement (−$U_S$), et un quatrième transistor ($T_{23}$), dont la base est reliée au collecteur du troisième transistor ($T_{22}$), dont l'émetteur est relié au point de potentiel de référence ($O_S$) et dont le collecteur est relié, par l'intermédiaire d'une cinquième résistance ($R_{33}$), à la tension de fonctionnement (−$U_S$), la réalisation étant telle que le signal de sortie de forme impulsionnelle ($U'_I$) est susceptible d'être prélevé entre le collecteur du quatrième transistor ($T_{22}$) et le point de potentiel de référence ($O_S$).

12. Commutateur électronique marche-arrêt à effleurement selon l'une des revendications 1 et 9 à 11, caractérisé par le fait que le détecteur de passage par la valeur nulle du courant (12) est relié, par l'intermédiaire d'un multivibrateur monostable (13), au circuit logique (11), en vue du réglage d'une durée d'impulsions prédéterminée de son signal de sortie ($U'_I$) de forme impulsionnelle.

13. Commutateur électronique marche-arrêt à effleurement selon l'une des revendications 1 et 9 à 12, caractérisé par un circuit logique (11) de constitution suivante: un multivibrateur bistable (21) dont l'entrée d'activation (S) est reliée à la sortie du multivibrateur monostable (13) et dont l'entrée de remise à l'état initial (R) est reliée, par l'intermédiaire d'un inverseur (20), à la sortie du détecteur de passage par la valeur nulle de la tension (10), une première porte ET (22) qui est reliée par une entrée à une sortie complémentaire ($\overline{Q}$) du multivibrateur bistable (21) et, par une autre entrée, à la sortie du détecteur de passage par la valeur nulle de la tension (10), une porte OU (23) qui est reliée par une entrée à la sortie de la première porte ET (22) et par un autre entrée à la sortie du multivibrateur monostable (13), et une seconde porte ET (24) qui est reliée par une entrée à la sortie de la porte OU (23) et par une autre entrée au détecteur (14) et par sa sortie à l'électrode de commande (G) du commutateur à semiconducteurs contrôlable (5).

14. Commutateur électronique marche-arrêt à effleurement selon la revendication 13, caractérisé par le fait que le détecteur (14) est relié, par l'intermédiaire d'un préamplificateur (15) et d'un dispositif à retard (16), à l'entrée de commande d'un multivibrateur marche-arrêt (17), dont la sortie est reliée à l'autre entrée de la seconde porte ET (24) du circuit logique (11).

15. Commutateur électronique marche-arrêt à effleurement selon la revendication 14, caractérisé par le fait que le circuit logique (11) comporte, en outre, un multivibrateur monostable (25) attaqué par la sortie du multivibrateur marche-arrêt (17), de même qu'une seconde porte OU (26) et que la sortie du multivibrateur monostable (25) est reliée à une entrée de la seconde porte OU (26), la sortie de la seconde porte ET (24) est reliée à une autre entrée de la seconde porte OU (26) et la sortie de la seconde porte OU (26) est reliée à l'électrode de commande (G) du commutateur à semiconducteurs contrôlable (5).

16. Commutateur électronique marche-arrêt à effleurement selon l'une des revendications 1 à 8 et 10 à 11, caractérisé par le fait que le circuit de commande (110) comporte un détecteur de passage pour la valeur nulle de la tension (10) qui, lorsque le commutateur à semiconducteurs contrôlable (15) est bloqué et que de ce fait la charge (L) est débranchée, émet, en tant que fonction des passages pour la valeur nulle de la tension alternative de sortie ($U_T$), un signal de sortie de forme impulsionnelle ($U_U$) et un dispositif logique commuté dans son état efficace par un signal de branchement provenant du détecteur (14) et du signal de sortie de forme impulsionnelle ($U_U$) du détecteur de passage pour la valeur nulle de la tension (10), ledit circuit logique (110) servant à mémoriser le signal de sortie de forme impulsionnelle du détecteur de passage pour la valeur nulle de la tension (10), dans l'électrode de commande (G) du commutateur à semiconducteurs contrôlable (5), et que le dispositif logique (110) comporte une porte ET (111) qui est reliée, par une entrée, à la sortie du détecteur de passage pour la valeur nulle de la tension (10) et, par une autre entrée, au détecteur (14), un inverseur (112) qui est relié, par son entrée, au détecteur (14), et un multivibrateur bistable (113) qui est relié, par son entrée d'activation (S), à la sortie de la porte ET (111) qui est reliée, par une entrée de remise à l'état initial (R), à la sortie de l'inverseur (112), et qui est relié, par une sortie (Q) commutée dans sa position efficace par un signal au niveau de son entrée d'activation (S), à l'électrode de commande (G) du commutateur à semiconducteurs contrôlable (5).

# FIG 1

FIG 2A

FIG 2B

FIG 2C

FIG 2D

FIG 2E

FIG 2F

FIG 2G

FIG 2H

17

# FIG 3

FIG 4A $i_L$

FIG 4B $U_D$

FIG 4C $i_{T\,EIN}$

FIG 4D $U'_I$

FIG 5

FIG 6

FIG 7

# FIG 8

# FIG 9

# FIG 10

FIG 11